# EUROPEAN PATENT SPECIFICATION

(11) **EP 3 043 326 B1**
(45) Date of publication and mention of the grant of the patent: **10.10.2018**
(21) Application number: 15170726.2
(22) Date of filing: 04.06.2015
(51) Int. Cl.: G07F 17/00, A47B 67/00, A47B 88/00

(54) **ACCESSABLE DRAWER ORGANISER WITH ITEM DISPLAY PANEL**
ZUGÄNGLICHER SCHUBLADENORGANISATOR ARTIKEL MIT ANZEIGETAFEL
ORGANISATEUR DE TIROIR ACCESSIBLE AVEC PANNEAU D'AFFICHAGE D'ARTICLE

(30) Priority: 06.01.2015 US 201514544430
(43) Date of publication of application: 13.07.2016
(73) Proprietor: iMicrodata Corporation, San Jose, CA 95119 (US)
(72) Inventor: Zhu, Shengbo, San Jose, California 95123 (US); Huang, Su Shiong, Bellevue, Washington 98004 (US)
(74) Representative: Boult Wade Tennant LLP

(56) References cited:
- US-A- 5 721 531
- US-A- 5 977 875
- US-A1- 2008 144 293
- US-A1- 2011 304 456
- US-A1- 2014 191 633
- US-A1- 2014 210 594

## Description

### BACKGROUND OF THE INVENTION

This invention relates to drawer organizer systems in general, and in particular to an improved addressable drawer organizer with an item display panel and other useful features.

Drawer organizer systems are known and are used generally to store small items in drawers which are slidably mounted in a cabinet designed for this purpose. The cabinet is usually fixed to a wall or a support surface, such as a work bench. Each drawer typically has a drawer pull mounted on a front panel so that a user can slide the drawer outwardly from the cabinet and gain access to the contents of the drawer. Cabinets and drawers have been fabricated from both metal and plastic, with some drawer organizers using metal for both the cabinet and the drawers, others using plastic for both the cabinet and the drawers, and others using a metal cabinet and plastic drawers. The plastic materials used in the past have been either opaque or translucent.

Many types of items can be stored in a drawer organizer. Some examples are fasteners of several kinds, such as nuts, bolts, washers, sheet metal screws, and wood screws; grommets of various sizes; O-rings; electrical connectors; small electronic components, such as diodes, resistors, and capacitors; and medications of various kinds, such as prescription pharmaceuticals, over-the-counter medical remedies and the like. Drawer organizers are found in homes, business premises, workshops and manufacturing facilities, and have proven to be useful in a wide variety of situations requiring the organized storage of small items for future access.

A principal difficulty encountered with the use of drawer organizers lies in the manner of retrieving desired items from the collection of items stored in the several drawers in a given cabinet. In particular, retrieving the correct item requires identifying the contents of individual drawers until the correct drawer is found. In some applications, visual inspection through a transparent front drawer panel is the technique relied upon to identify the types of articles contained in that drawer. In other applications, small labels are adhered to the front panel of the drawers, with each label containing a brief description of the articles contained in that drawer. Both techniques are less than optimal. The visual inspection technique divulges only a minimum of subjective information about the contained articles. Similarly, the label technique is limited by the amount of space available on the label to describe the contained articles. Depending on the nature of the contained articles, the label technique cannot adequately distinguish the articles in one drawer from the articles in other drawers. For example, if the contained articles are resistors of different resistance values and power ratings, it is at best difficult to adequately distinguish among the several choices. The label technique also suffers from the disadvantage that the labels must be changed whenever the kinds of articles contained in a given drawer are changed. Both techniques are relatively inefficient in enabling quick identification of the correct drawer in applications having large collections of different types of articles. In general, the larger the number of drawers, the slower the access time to the contents of the desired drawer.

U.S. patent number 6,348,864 issued February 19, 2002 for "Organizer Management System Using R.F. identification", the disclosure of which is hereby incorporated by reference, discloses an organizer management system which is devoid of the above-noted limitations and disadvantages, which can be implemented using any articles suitable for containment in an organizer drawer, and which greatly facilitates ready access to specific items contained in organizer drawers. More particularly, the '864 patent discloses a drawer organizer management system using r.f. identification of individual drawers in a cabinet. The system includes a cabinet having a structure including a rear wall for providing a plurality of drawer locations, the cabinet having a plurality of pairs of external terminals adapted to be coupled to an r.f. signal generator for receiving r.f. signals from the generator, with each of the external terminal pairs being arranged preferably on the rear wall in a position corresponding to a different one of the drawer locations.

A plurality of drawers are each slidably mounted in a different one of the drawer locations between a closed position and an opened position. Each of the plurality of file drawers has a pair of electrically conductive drawer terminals adjacent the rear thereof and are adapted to engage a corresponding pair of the external terminals, a pair of electrical r.f. signal conductors coupled to the drawer terminals, and an r.f. circuit coupled to the pair of r.f. signal conductors. Each of the r.f. circuits has a crystal resonant at a specific frequency and a visible indicator activated whenever the associated crystal detects an r.f. signal at the specific frequency of that crystal. The resonant frequency of each of the crystals is different from the remaining ones of the crystals so that an r.f. signal of a specific frequency applied to the external input terminals of the cabinet causes only one of the plurality of crystals to resonate and only the visible indicator associated to that crystal to be activated.

Each of the drawers has a front panel, and each of the indicators is located on the front panel of the corresponding drawer so as to provide a visible indication of a resonant crystal in the drawer when the drawers are closed. Each of the visible indicators preferably comprises an LED. Each of the drawers also has a rear panel, and the pair of electrically conductive drawer terminals is preferably mounted on the rear panel. Each of the drawers is further provided with a positive detent mechanism for promoting contact between the electrically conductive drawer terminals and the external terminals. Each of the drawers is also provided with a pair of positive contact elements, such as a pair of springs, for promoting contact between the electrically conductive drawer terminals and the external terminals.

The system is used to locate the drawer containing a desired type of item in the following manner. A user enters the identity of a desired item in the system computer, either via a keyboard or by using a mouse to select an item from a list displayed on the computer monitor. In response, the computer performs a table-lookup from a set of frequencies which are uniquely associated to the items stored in the drawers. Once the corresponding frequency has been found, the computer instructs the r.f. signal generator to generate r.f. signals of the correct frequency. These r.f. signals are coupled to the individual cabinet drawers, and the r.f. circuit having the crystal of the correct frequency resonates, thereby illuminating the corresponding visible indicator on the drawer front panel. The user now knows which drawer contains the desired item.

The r.f. signal technology used in the '864 system essentially provides drawer identification signals (the r.f. signals of a specific frequency) and a drawer address comparison circuit for each drawer (the r.f.circuits each having a crystal of a unique specific frequency). This arrangement can be modified by replacing the r.f. technology with host computer generated digital drawer identification signals and address decoders located in each drawer circuit so that the host computer generates drawer identification signals which are broadcast to all drawer cabinets in the system using either wired or wireless communication links. In such an arrangement, the received drawer identification signals are inspected by the address decoders in each drawer circuit and the drawer circuit containing the address decoder having the unique address specified by the received drawer identification signal responds by activating the visible indicator on the front panel of that drawer.

The '864 system provides a low cost, effective and convenient technique for facilitating the location of specific items contained in a drawer organizer system. In addition, the '864 system eliminates, or substantially reduces the need for reliance on the labelling practice followed in setting up drawer organizer systems. Moreover, the '864 system affords great flexibility in arranging drawer organizers. In particular, the identity of the items in any given drawer can be easily changed by modifying the description in the system computer. Also, additional drawers can be added to expand the inventory held in the system, and existing drawers can be deleted from the system by changing the information stored in the computer.

While possessing all the advantages noted above over previous drawer organizer systems, the '864 system requires the use of the pair of electrically conductive drawer terminals adjacent the rear thereof to engage the corresponding pair of external r.f .signal terminals, the inclusion of the pair of electrical r.f. signal conductors coupled to the drawer terminals and the drawer r.f. circuit, and the provision of the positive detent spring mechanism for promoting contact between the electrically conductive drawer terminals and the external terminals. These elements require careful installation in order to construct a fully functioning unit, which adds cost to the manufacturing process, and can be prone to mechanical and electrical failure. In addition, the simple LED indicator used to signify the correct drawer containing the sought item provides no visual information about the identity of the item stored in the designated drawer.

US 2014/0210594 provides a compartment storage container for use in a collective objects management system. The container may be installed within a drawer of a filing cabinet.

US 5,721,531 discloses a monitoring arrangement for a hanging file folder for identifying information contained in an electronic file folder locator system, using a file folder label holder containing an addressable switch and a memory storing identifying information unique to the file folder. US 5,977,875 describes a collective objects management system for objects such as documents contained in file folders in drawers of filing cabinets, each file folder having an electrical circuit with a visible indicator mounted on the file folder.

US 2014/191633 discloses a storage container for use in a documents management system with remote location of file folders positioned on support members supplied with file folder search signals. US 2011/304456 provides a collective objects management system where each file folder has a visible indicator and an electrical circuit with an address decoder to detect a match with an incoming address.

US 2008/144293 relates to rack mounting of electronic equipment, and the provision of drawer slides with integrated mating contacts on each portion of the slide.

### SUMMARY OF THE INVENTION

The invention provides a drawer organizer as set out in claim 1.

Embodiments of the invention comprise an addressable drawer organizer which requires no separate signal conductors for coupling the externally supplied drawer identification signals to the drawer address comparison circuit, which eliminates the need for a positive detent mechanism to ensure effective electrical contact between the externally supplied drawer identification signals and the drawer address comparison circuit; and which further provides visible drawer item information to the user.

From an apparatus standpoint, embodiments of the invention comprise a drawer organizer comprising a cabinet having a structure providing a plurality of drawer locations; a plurality of drawers each slidably mounted in a different one of the drawer locations between a closed position and an opened position, each of the plurality of drawers having a front panel and a plurality of electronic drawer components including a display device mounted on the front panel for displaying information about items assigned to that drawer; a pair of ohmic conductors providing electrical connection between the plurality of electronic components in the plurality of drawers and an associated controller; and a plurality of pairs of electrically conductive drawer slides each secured between a different one of the plurality of drawers and confronting portions of the cabinet to provide an electrically conductive slidable drawer mount for the corresponding one of the plurality of drawers, each one of the pair of electrically conductive drawer slides being electrically coupled to a different one of the pair of ohmic conductors and the plurality of electronic drawer components in the corresponding one of the plurality of drawers. The front panel of each of the drawers preferably includes an electrically activatable visible indicator, such as an LED. The display device preferably comprises a matrix display, such as an organic light emitting diode display. The plurality of drawers each has a pair of opposing side walls, and each of the plurality of pairs of electrically conductive drawer slides is preferably secured to the opposing side walls of the corresponding one of the plurality of drawers.

Preferably, the number of the plurality of drawer locations is equal to the number of the plurality of drawers.

The plurality of electronic drawer components includes a CPU for enabling communication with the associated controller, and a display device driver for providing display device driving signals.

From a process standpoint, embodiments of the invention comprise a method for facilitating the drawer location of a sought item in a drawer organizer having individual drawers each including a drawer CPU, an item information display, a display driver, and an activatable visual indicator, such as an LED. The method proceeds by having a user enter the identification of a sought item, such as "aspirin 81 mg.", into a host computer using a conventional keyboard coupled to the host computer. The computer consults a stored master list of items registered in the system to find the drawer address identification information of the sought item and transmits this information to a controller. The controller then converts the drawer address identification information received from the host computer to a drawer address and conveys this address to all drawer CPU units. The drawer CPU containing the sought drawer address sends an address match signal to the controller, which transmits this result to the host computer. The host computer then consults the stored master list to retrieve the display information associated with the sought item and transmits this information to the controller, which relays this information to the drawer CPU having the matched address. The drawer CPU then supplies this display information to the display driver, which causes the display to display the item information. After the user retrieves the item from the correct drawer, the user operates the host computer keyboard to signify that the item has been removed from the drawer. The host computer then terminates the transmission of the display information.

For a fuller understanding of the nature and advantages of the invention, reference should be made to the ensuing detailed description taken in conjunction with the accompanying drawings.

### BRIEF DESCRIPTION OF THE DRAWINGS

FIG. 1 is a perspective view of a drawer organizer incorporating the invention;
FIG. 2 is a front plan view of a single drawer of the embodiment of Fig. 1;
FIG. 3 is a block diagram illustrating the major electronic components of a single drawer;
FIG. 4 is a top plan view of a single drawer; and
Fig. 5 is a schematic top plan view of a plurality of drawers illustrating the connection of several drawers to the drawer identification signal conductors.

### DETAILED DESCRIPTION OF THE PREFERRED EMBODIMENTS

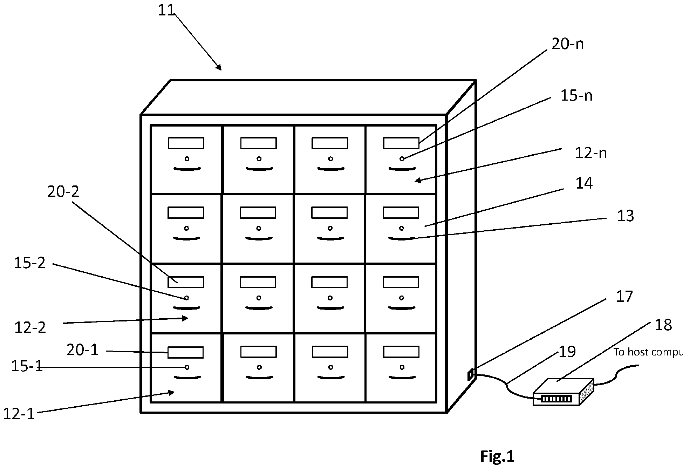

Turning now to the drawings, Fig. 1 is a perspective view of a drawer organizer incorporating the invention. As seen in this Fig., a cabinet generally designated with reference numeral 11 has a plurality of open locations for slidably housing a plurality of individual, essentially identical organizer drawers 12-1, 12-2, ...,12- n (with 16 drawers being illustrated in Fig. 1). Each drawer 12-1, 12-2, ...,12-n has substantially similar physical dimensions so that any of the drawers 12-1, 12-2, ..., 12-n can be installed in any of the drawer locations in cabinet 11. Each drawer 12-1, 12-2, ..., 12-n has a drawer pull 13 integrally formed with or attached to a front drawer panel 14 to facilitate opening and closing of the drawer. Each drawer 12-1, 12-2, ..., 12-n has a visible indicator 15-1, 15-2, ..., 15-n mounted on the front drawer panel 14. Visible indicators 15-1, 15-2, ..., 15n are preferably low cost light emitting diodes (LEDs), although other types of visible indicators, such as a flashing LED, incandescent lamps or liquid crystal displays (LCDs), may be used for this purpose.

Cabinet 11 includes a connector socket 17, preferably a USB connector, to which a controller 18 is electrically connected by means of a USB cable 19. Controller 18 is preferably a type AT89C2051 unit available from Intel Corporation of Santa Clara, California and an address encoder such as a type PT2262 unit available from Princeton Technology Corporation of Taipei, Taiwan, and serves to receive drawer identification signals specifying a sought drawer from a host computer (not illustrated), furnish drawer address signals to circuits in each drawer (described below), and relay resulting signals from the drawer circuits to the host computer. Controller 18 may be configured to communicate with the host computer using wireless communication, such as wi-fi, or hard wired communication links.

With reference to Figs. 1-4, each drawer 12-i is provided with a display panel 20-i for displaying information identifying the contents of a particular drawer. Preferably, display panel is a type UG-2832 organic light emitting diode (OLED) 128 X 32 pixel display unit available from Univision Semiconductor, Inc of Taiwan. The display information is supplied to display panel 20i from the host computer via controller 18.

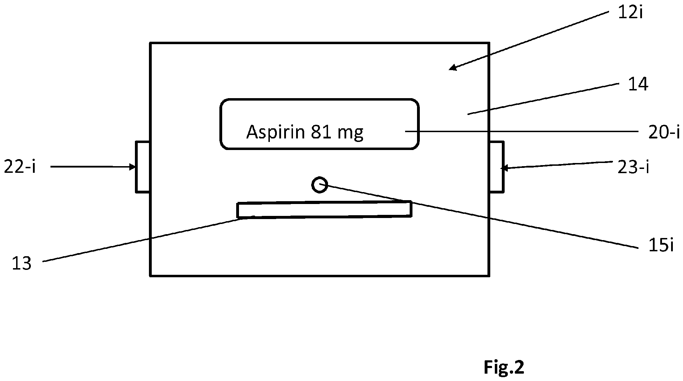

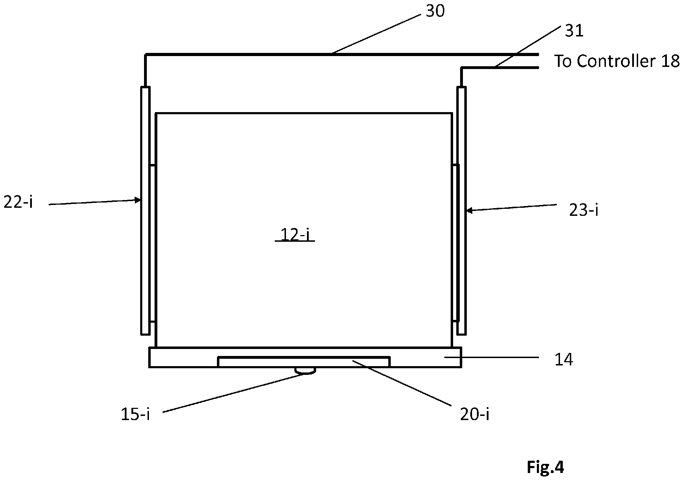

Each drawer 12-i is slidably mounted in the corresponding cabinet drawer opening by conventional two-part drawer slides 22-i, 23-i. Preferably, drawer slides 22-i, 23-i are type CWH-10 electrically conductive drawer slides available from Cabinetmaker Warehouse of Jamestown, Tennessee. The inner part of each drawer slide 22-i, 23-i is secured, respectively, to the left and right side walls of the drawer 12-i (see Figs.2 and 4). The outer part of each drawer slide 22-i, 23-i is secured to the adjacent wall portion of the opening in cabinet 11. Ball bearings located between the inner part and the outer part of each drawer slide 22-i, 23-i provide the relative sliding movement required between the drawer 12-i and the cabinet 11.

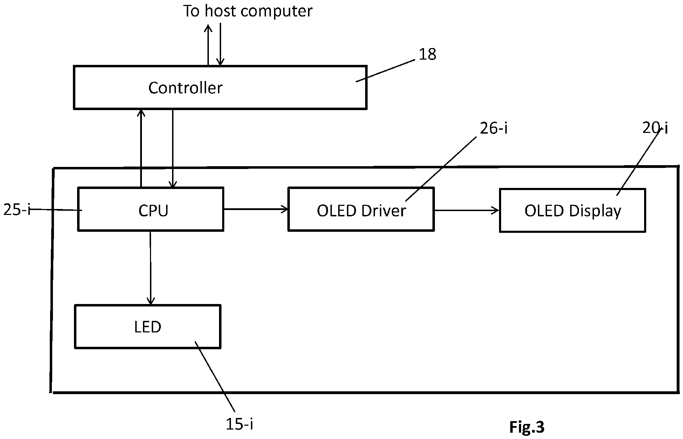

Fig. 3 is a block diagram illustrating the major electronic components of a single drawer 12-i. As seen in this Fig. 3, these major components include a CPU 25-i, an OLED driver 26-i, and the OLED display 20-i, which are all mounted on a circuit board 28-i, and the LED 15-i mounted on the front drawer panel 14. OLED driver 26-i is preferably a type SSD1305 driver unit available from Solomon Systech of Hong Kong and functions to convert display information instruction signals from CPU 25-i to display driver signals for display 20-i. CPU 25-i is preferably a type PIC16F1823 unit available from Microchip Technology, Inc. of Chandler, Arizona and has several functions. First CPU 25-i receives drawer address signals from controller 18 and compares these signals with the drawer address stored in a memory portion of CPU 25-i. If there is a match between the drawer address signals and the stored drawer address, CPU 25-i sends a match signal to controller 18, which in turn informs the host computer that the correct drawer has been located. In response, the host computer sends display information to controller 18, which conveys this information to CPU 25-i. CPU 25-i , in turn, furnishes this display information to OLED driver 26-i, which applies the correct drive signals to OLED display 20-i thereby causing the information to be visibly displayed. In addition, CPU 25-i causes LED 15-i to be activated so that the correct drawer can be visually located and opened.

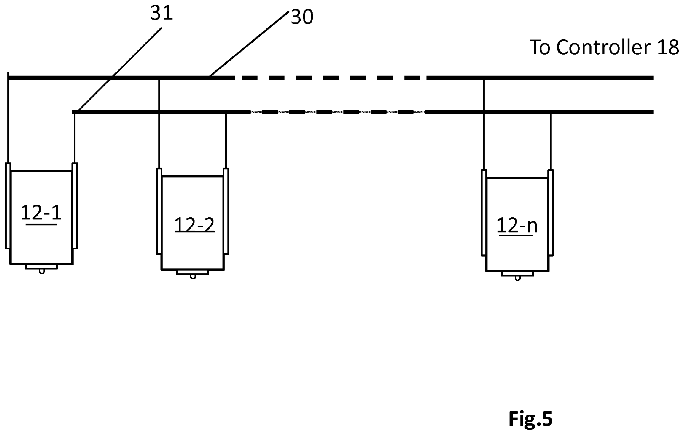

A significant feature of the invention lies in the manner in which the drawer electronic components are electrically coupled to the controller 18. As best seen in Figs. 4 and 5, the electronic components of each drawer 12-i are coupled to a pair of ohmic conductors 30, 31 via the drawer slides 22-i, 23-i. As best seen in Fig. 5, the drawer slides 22-i, 23-i of all drawers 12-i are all connected in parallel to the conductors 30, 31, which are connected to controller 18.This eliminates the need for separate and discrete ohmic conductors as employed in previously known drawer organizers, which simplifies the manufacturing process by eliminating the separate conductors, reduces the manufacturing cost by simplifying the assembly process, and reduces communication failures due to interruptions in connectivity due to manipulation of the drawers in and out of the cabinet 11. In addition, this ohmic arrangement ensures that power and data are still supplied to the drawer electronic components after the drawer is opened, which maintains the LED 15-i and display 20-i active even when the drawer is in the open position. This provides visual feedback to the user who is in the process of retrieving one or more items from the designated, drawer.

In use, the user enters the identification of a sought item, such as "aspirin 81 mg.", into the host computer using a conventional keyboard coupled to the host computer. The computer consults a stored master list of items registered in the system to find the drawer address identification information of the sought item and transmits this information to controller 18. Controller 18 then converts the drawer address identification information received from the host computer to a drawer address and conveys this address to all drawer CPU units. The drawer CPU containing the sought drawer address sends the address match signal to the controller 18, which transmits this result to the host computer. The host computer then consults the stored master list to retrieve the display information associated with the sought item and transmits this information to the controller 18, which relays this information to the drawer CPU having the matched address. The drawer CPU then supplies this display information to the display driver, which causes the display to display the item information. After the user retrieves the item from the correct drawer, the user operates the host computer keyboard to signify that the item has been removed from the drawer. The host computer then terminates the transmission of the display information.

It has been observed during use of the system that occasionally power and/or data can be temporarily interrupted due to mechanical motion of the drawer slide components. When this happens, the display information might be lost. To overcome this potential loss of display information, the host computer is configured to repeatedly transmit the display information to controller 18 on a periodic basis, after the controller 18 has informed the host computer that the sought drawer has been located. Preferably, a repetition interval of once every 0.5 seconds has been found to be effective.

As will now be apparent, drawer organizer systems incorporating the invention provide a number of significant advantages absent from the prior art. Firstly, as noted above, the elimination of the separate and discrete ohmic conductors simplifies the manufacturing process by eliminating the separate conductors, reduces the manufacturing cost by simplifying the assembly process, and reduces communication failures due to interruptions in connectivity due to manipulation of the drawers in and out of the cabinet 11. In addition, this ohmic arrangement ensures that power and data are still supplied to the drawer electronic components after the drawer is opened, which maintains the LED 15-i and display 20-i active even when the drawer is in the open position. This provides visual feedback to the user who is in the process of retrieving one or more items from the designated drawer. In addition, the provision of an item display panel enables the user to visually verify that the drawer designated by the activated LED 15 is the designated drawer for the sought item. Lastly, repeated transmission of the display information from the host computer to the cabinet controller ensures that temporary interruption of power and data to the drawer major electronic components will not invalidate the display information.

Although the above provides a full and complete disclosure of the preferred embodiments of the invention, various modifications, alternate constructions and equivalents will occur to those skilled in the art. For example, while the invention has been described with reference to a particular repetition period for the display information, other intervals may be chosen, as desired. Further, other major electronic drawer components than those specified for the preferred embodiment may be chosen, if desired. Also, although the drawer slides have been described and illustrated as being secured to opposing sides of each drawer, other configurations are possible, such as securing both slides to the bottom of the drawer. Therefore, the above should not be construed as limiting the invention, which is defined by the appended claims.

## Claims

1. A drawer organizer comprising:
a cabinet (11) having a structure providing a plurality of drawer locations;
a plurality of drawers (12) each slidably mounted in a different one of said drawer locations between a closed position and an opened position, each of said plurality of drawers having a front panel (14) and a plurality of electronic drawer components, and
a pair of ohmic conductors (30,31) providing electrical connection between said plurality of electronic components in said plurality of drawers and an associated controller (18),
**characterised in that**:
the plurality of electronic drawer components of each of said plurality of drawers includes:
a display device (20) mounted on said front panel for displaying information about items assigned to that drawer;
a CPU (25) arranged to receive drawer address signals from the associated controller (18), to compare the received drawer address signals with a drawer address stored in said CPU, to send a match signal to said associated controller when the received drawer address signals and the drawer address stored in said CPU match, to receive display information sent from said associated controller in response to receiving the match signal, and to generate display information instruction signals corresponding to the display information; and
a driver unit (26) coupled to said CPU and said display device and arranged to convert said display information instruction signals from said CPU to display driver signals for said display device, and **in that** the drawer organiser further comprises:
a plurality of pairs of electrically conductive drawer slides (22, 23), each such pair being secured to a different one of said plurality of drawers (12) to provide an electrically conductive slidable drawer mount for that drawer, each electrically conductive drawer slide of each pair providing electrical connection between a different one of said pair of ohmic conductors and said plurality of electronic drawer components in the corresponding drawer, such that the plurality of pairs of electrically conductive drawer slides are connected in parallel to the pair of ohmic conductors.

2. The drawer organizer of claim 1 wherein said front panel has an electrically activatable visible indicator (15) coupled to said CPU.

3. The drawer organizer of claim 2 wherein said visible indicator (15) comprises an LED.

4. The drawer organizer of any preceding claim wherein said display device (20) comprises a matrix display.

5. The drawer organizer of claim 4 wherein said matrix display comprises an organic light emitting diode display.

6. The drawer organizer of any preceding claim wherein said plurality of drawers each has a pair of opposing side walls; and wherein each of said plurality of pairs of electrically conductive drawer slides is secured to said opposing side walls of the corresponding one of said plurality of drawers.

7. The drawer organizer of any preceding claim wherein the number of said plurality of drawer locations is equal to the number of said plurality of drawers.

## Patentansprüche

1. Schubladen-Organisierungseinrichtung, umfassend:
einen Schrank (11), welcher eine Struktur aufweist, welche eine Mehrzahl von Schubladenpositionen bereitstellt;
eine Mehrzahl von Schubladen (12), welche jeweils in einer unterschiedlichen der Schubladenpositionen zwischen einer geschlossenen Position und einer geöffneten Position gleitbar montiert sind, wobei jede aus der Mehrzahl von Schubladen ein vorderes Paneel (14) und eine Mehrzahl von elektronischen Schubladenkomponenten aufweist, und
ein Paar von Ohm'schen Leitern (30, 31), welche eine elektrische Verbindung zwischen der Mehrzahl von elektronischen Komponenten in der Mehrzahl von Schubladen und einer zugeordneten Steuereinheit (18) herstellen,
**dadurch gekennzeichnet, dass**:
die Mehrzahl von elektronischen Schubladenkomponenten von jeder aus der Mehrzahl von Schubladen umfasst:
eine Anzeigevorrichtung (20), welche an dem vorderen Paneel zum Anzeigen von Informationen über Gegenstände montiert ist, welche dieser Schublade zugeordnet sind;
eine CPU (25), welche dazu eingerichtet ist, Schubladen-Adresssignale von der zugeordneten Steuereinheit (18) zu erhalten, um die erhaltenen Schubladen-Adresssignale mit einer Schubladenadresse zu vergleichen, welche in der CPU gespeichert ist, um ein Übereinstimmungssignal zu der zugeordneten Steuereinheit zu senden, wenn die erhaltenen Schubladen-Adresssignale und die in der CPU gespeicherte Schubladenadresse übereinstimmen, um Anzeigeinformationen zu empfangen, welche von der zugeordneten Steuereinheit als Reaktion auf ein Empfangen des Übereinstimmungssignals gesendet werden, und Anzeigeinformations-Anweisungssignale zu erzeugen, welche den Anzeigeinformationen entsprechen; und
eine Treibereinheit (26), welche mit der CPU und der Anzeigevorrichtung gekoppelt ist und dazu eingerichtet ist, die Anzeigeinformations-Anweisungssignale von der CPU in Anzeige-Treibersignale für die Anzeigevorrichtung umzuwandeln,
und dass die Schubladen-Organisationseinrichtung ferner umfasst:
eine Mehrzahl von Paaren von elektrisch leitfähigen Schubladen-Gleitelementen (22, 23), wobei jedes solche Paar an einer anderen aus der Mehrzahl von Schubladen (12) gesichert ist, um eine elektrisch leitfähige gleitbare Schubladenmontage zu dieser Schublade bereitzustellen, wobei jedes elektrisch leitfähige Schubladen-Gleitelement von jedem Paar eine elektrische Verbindung zwischen einem anderen aus dem Paar von Ohm'schen Leitern und der Mehrzahl von elektronischen Schubladenkomponenten in der entsprechenden Schublade bereitstellt, so dass die Mehrzahl von Paaren von elektrisch leitfähigen Schubladen-Gleitelementen parallel zu dem Paar von Ohm'schen Leitern verbunden sind.

2. Schubladen-Organisierungseinrichtung nach Anspruch 1, wobei das vordere Paneel einen elektrisch aktivierbaren sichtbaren Anzeiger (15) aufweist, welcher mit der CPU gekoppelt ist.

3. Schubladen-Organisierungseinrichtung nach Anspruch 2, wobei der sichtbare Anzeiger (15) eine LED umfasst.

4. Schubladen-Organisierungseinrichtung nach einem der vorhergehenden Ansprüche, wobei die Anzeigevorrichtung (20) eine Matrix-Anzeige umfasst.

5. Schubladen-Organisierungseinrichtung nach Anspruch 4, wobei die Matrix-Anzeige eine organische lichtemittierende Diodenanzeige umfasst.

6. Schubladen-Organisierungseinrichtung nach einem der vorhergehenden Ansprüche, wobei die Mehrzahl von Schubladen jeweils ein Paar von gegenüberliegenden Seitenwänden aufweist, und wobei jedes aus der Mehrzahl von Paaren von elektrisch leitfähigen Schubladen-Gleitelementen an die gegenüberliegenden Seitenwände der entsprechenden einen aus der Mehrzahl von Schubladen gesichert ist.

7. Schubladen-Organisierungseinrichtung nach einem der vorhergehenden Ansprüche, wobei die Anzahl der Mehrzahl von Schubladenpositionen gleich der Anzahl der Mehrzahl von Schubladen ist.

## Revendications

1. Système à compartiments de tiroirs comprenant :
une armoire (11) ayant une structure fournissant une pluralité d'emplacements pour tiroirs ;
une pluralité de tiroirs (12), chacun étant monté en coulissement dans un emplacement différent desdits emplacements pour tiroirs entre une position fermée et une position ouverte, chacun de ladite pluralité de tiroirs ayant un panneau avant (14) et une pluralité de composants de tiroir électroniques, et
une paire de conducteurs ohmiques (30, 31) fournissant une liaison électrique entre ladite pluralité de composants électroniques dans ladite pluralité de tiroirs et un dispositif de commande associé (18),
**caractérisé en ce que** :
la pluralité de composants de tiroir électroniques de chacun de ladite pluralité de tiroirs comporte :
un dispositif d'affichage (20) monté sur ledit panneau avant pour afficher des informations concernant les articles attribués à ce tiroir ;
une unité CPU (25) agencée pour recevoir des signaux d'adresse de tiroirs provenant du dispositif de commande associé (18), pour comparer les signaux d'adresse de tiroir reçus à une adresse de tiroir mémorisée dans ladite unité CPU, pour envoyer un signal de correspondance audit dispositif de commande associé lorsque les signaux d'adresse de tiroir reçus et l'adresse de tiroir mémorisée dans ladite unité CPU se correspondent, pour recevoir des informations d'affichage envoyées à partir dudit dispositif de commande associé en réponse à la réception du signal de correspondance, et pour générer des signaux d'instruction d'informations d'affichage correspondant aux informations d'affichage ; et
une unité pilote (26) couplée à ladite unité CPU et audit dispositif d'affichage et agencée pour convertir lesdits signaux d'instruction d'informations d'affichage provenant de ladite unité CPU en des signaux de pilote d'affichage pour ledit dispositif d'affichage, et
une pluralité de paires de glissières de tiroir électroconductrices (22, 23), chacune de ces paires étant fixée à un tiroir différent de ladite pluralité de tiroirs (12) pour fournir un montage de tiroir coulissant électroconducteur pour ce tiroir, chaque glissière de tiroir électroconductrice de chaque paire fournissant une liaison électrique entre un conducteur différent de ladite paire de conducteurs ohmiques et ladite pluralité de composants de tiroir électroniques dans le tiroir correspondant, de sorte que la pluralité de paires de glissières de tiroir électroconductrices soit reliée en parallèle à la paire de conducteurs ohmiques.

2. Système à compartiments de tiroirs de la revendication 1, dans lequel ledit panneau avant a un indicateur visuel (15) pouvant être électriquement activé couplé à ladite unité CPU.

3. Système à compartiments de tiroirs de la revendication 2, dans lequel ledit indicateur visuel (15) comprend une diode LED.

4. Système à compartiments de tiroirs de l'une des revendications précédentes, dans lequel ledit dispositif d'affichage (20) comprend un afficheur matriciel.

5. Système à compartiments de tiroirs de la revendication 4, dans lequel ledit afficheur matriciel comprend un afficheur à diodes électroluminescentes organiques.

6. Système à compartiments de tiroirs de l'une des revendications précédentes, dans lequel ladite pluralité de tiroirs ont chacun une paire de parois latérales opposées ; et dans lequel chacune de ladite pluralité de paires de glissières de tiroir électroconductrices est fixée auxdites parois latérales opposées du tiroir correspondant de ladite pluralité de tiroirs.

7. Système à compartiments de tiroirs selon l'une des revendications précédentes, dans lequel le nombre de ladite pluralité d'emplacements pour tiroirs est égal au nombre de ladite pluralité de tiroirs.
